**Europäisches Patentamt**

**European Patent Office**

**Office européen des brevets**

(19)

(11)  **EP 1 281 976 A1**

(12)  **EUROPÄISCHE PATENTANMELDUNG**

(43) Veröffentlichungstag:
**05.02.2003  Patentblatt 2003/06**

(51) Int Cl.⁷: $G01R\ 19/00$

(21) Anmeldenummer: **01118239.1**

(22) Anmeldetag: **30.07.2001**

(84) Benannte Vertragsstaaten:
**AT BE CH CY DE DK ES FI FR GB GR IE IT LI LU MC NL PT SE TR**
Benannte Erstreckungsstaaten:
**AL LT LV MK RO SI**

(71) Anmelder: **aix ACCT Systems GmbH**
**52068 Aachen (DE)**

(72) Erfinder:
• **Szot, Krzysztof, Dr.**
  **52428 Jülich (DE)**
• **Tiedke, Stephan**
  **52379 Langerwehe (DE)**

(74) Vertreter: **Gille Hrabal Struck Neidlein Prop Roos**
**Patentanwälte**
**Brucknerstrasse 20**
**40593 Düsseldorf (DE)**

(54)  **Elektrometer für die Messung schneller Spannungsänderungen**

(57)     Die Erfindund betrifft ein Elektrometer zur Messung einer elektrischen Spannung sowie auf die Angabe eines bevorzugten Anwendungsgebietes.

Das Elektrometer weist Mittel zur Messung und Ausgabe einer elektrischen Spannung auf. Es umfasst Bauelemente, bei denen parasitäre Kapazitäten ($C_E$) im inneren der Bauelemente auftreten. Eine elektronische Einrichrung (4) vorhanden, die die auftretenden Potenzialdifferenzen bei den vorgenannten parasitären Kapazitäten registriert und registrierte Potenzialdifferezen eletronisch reduziert.

Das Elektrometer eignet sich insbesondere zur Messung von biologischen Zellpotenzialen.

FIG.1

**Beschreibung**

Die Erfindung betrifft ein Elektrometer zur Messung einer elektrischen Spannung sowie auf die Angabe eines bevorzugten Anwendungsgebietes.

Ein kommerziell erhältliches Elektrometer der eingangs genannten Art weist einen großen sogenannten Eingangswiderstand auf. Der Eingangswiderstand liegt typischerweise bei $10^{14}$ bis $10^{15}$ Ohm. Das Elektrometer umfasst diverse Bauelemente sowie ein Mittel zur Ausgabe des gemessenen Spannungswertes. Beim Mittel zur Ausgabe des Spannungswertes kann es sich um ein konventionelles Zeigergerät handeln. Moderner sind Displays, auf denen der gemessene Spannungswert digital angezeigt wird.

Als Bauelemente kann das Elektrometer integrierte Schaltkreise, MOSFET-Transistoren, elektrometrische Röhren, parametrische Verstärker usw. aufweisen.

Neben dem Eingangswiderstand wird ein Elektrometer der eingangs genannten Art durch eine Eingangskapazität charakterisiert. Eingangswiderstand und Eingangskapazität sind Bestandteil eines sogenannten Ersatzschaltbildes, mit dem das physikalische Verhalten eines Elektrometers an seinem Eingang beschrieben wird. Ein Eingangswiderstand bzw. eine Eingangskapazität ist also kein eigentliches reales Bauteil. Statt dessen ist die Eingangskapazität auf sogenannte Störkapazitäten zurückzuführen, die beim Elektrometer auftreten. Ein Elektrometer weist z. B. einen integrierten Schaltkreis aus, der über sogenannte Beinchen mit einer Platine verbunden ist. Zwischen zwei Beinchen eines solchen integrierten Schaltkreises tritt eine Kapazität auf. Streukapazitäten sind ferner im Inneren der eingangs genannten Bauteile vorhanden. So kann beispielsweise zwischen dem gate und dem source eines MOSFET-Transistors, der sich im Inneren eines der vorgenannten Bauelemente befindet, eine Streukapazität auftreten.

Eingangskapazität und Eingangswiderstand bilden die sogenannte Eingangsimpedanz.

Um schnelle Spannungsänderungen messen zu können, muss ein Elektrometer eingesetzt werden, dessen physikalisches Verhalten durch eine kleine Eingangskapazität beschrieben wird. Dies ist insbesondere dann der Fall, wenn der Widerstand, an dem der Spannungsabfall gemessen wird, sehr groß ist.

Ein typisches Beispiel ist die Messung der dielektrischen Polarisation von Bariumtitanat ($BaTiO_3$). $BaTiO_3$ weist einen sehr großen Ohmschen Widerstand auf.

Wird $BaTiO_3$ abwechselnd gestaucht und gestreckt, so erzeugt $BaTiO_3$ mit der entsprechenden Frequenz Spannungssignale. Wünschenswert ist, diese Signale auch dann messen zu können, wenn ein $BaTiO_3$-Kristall mit großer Frequenz gestaucht und gestreckt wird.

Eine Voraussetzung für die Messung der vorgenannten Spannungsänderungen ist, dass der Ohmsche Widerstand von $BaTiO_3$ sehr viel kleiner ist als der Eingangswiderstand des verwendeten Elektrometers. Ist diese Voraussetzung erfüllt, so gilt:

$$\tau = R_{BaTiO3} \times C_{Eingang}$$

$\tau$ ist ein Maß für die Bandbreite des Verstärkers, mit dem fehlerfrei gemessen werden kann. Der Kehrwert von $\tau$, also $1/\tau$ gibt an, bis zu welcher Frequenz Stauchungs- und Streckungsvorgänge bei einem $BaTiO_3$-Kristall gemessen werden kann.

Ist die eingangs genannte Bedingung nicht erfüllt, dass also der Ohmsche Widerstand von $BaTiO_3$ sehr viel kleiner als der Eingangswiderstand des Elektrometers ist, so ist eine genaue Messung der Spannung nicht möglich.

Bei den besten Elektrometern, die derzeit kommerziell erhältlich sind und die für die beispielhaft genannte Messung geeignet sind, beträgt die Eingangskapazität $10^{-12}$ F. Der Eingangswiderstand liegt, wie bereits erwähnt, dann bei $10^{14}$ bis $10^{15}$ Ohm. Mit einem solchen Gerät ist es nicht mehr möglich, Signaländerungen zu messen, die mit einer Frequenz oberhalb von 1 Hz variieren.

Aufgabe der Erfindung ist die Schaffung eines Elektrometers, mit dem schnelle Spannungsänderungen gemessen werden können, die an großen Ohmschen Widerständen abfallen.

Die Aufgabe der Erfindung wird durch ein Elektrometer mit den Merkmalen des ersten Anspruchs gelöst. Vorteilhafte Ausgestaltungen ergeben sich aus den Unteransprüchen.

Das anspruchsgemäße Elektrometer weist Bauelemente der eingangs genannten Art sowie ein Mittel zur Ausgabe des Spannungswertes auf. Bauartbedingt treten im Inneren der Bauelemente parasitäre Kapazitäten auf. Parasitäre Kapazitäten sind unerwünschte Streukapazitäten. Unerwünscht sind die Streukapazitäten, wenn diese zu einer Erhöhung der Eingangskapazität beitragen.

Im Unterschied zum Stand der Technik weist das Elektrometer eine elektronische Einrichtung auf, die die auftretenden Potenzialdifferenzen bei den vorgenannten parasitären Kapazitäten registriert und registrierte Potenzialdifferenzen elektronisch reduziert. Dem Fachmann sind grundsätzlich Potenzialnachführungseinrichtungen bekannt. Es handelt sich also hierbei um Einrichtungen, die Potenzialdifferenzen ermitteln und elektronisch ausgleichen. Es ist jedoch nicht bekannt, den eingangs genannten störenden Einfluss einer parasitären Kapazität durch Potenzialnachführung herabzusetzen, die auf Streukapazitäten im Inneren der eingangs genannten Bauelemente bewirkt werden.

Möglicherweise ist eine Potenzialnachführung bekannt, mit denen störende Einflüsse eliminiert werden, die auf Streukapazitäten außerhalb der Bauelemente zurückzuführen sind.

Es hat sich gezeigt, dass es zur Lösung der Aufgabe gerade auf die Eliminierung von unerwünschten Wirkungen ankommt, die auf Streukapazitäten im Inneren der Bauteile zurückzuführen sind. Gegenüber dem eingangs genannten Stand der Technik konnte die Eingangskapazität damit von $10^{-12}$ F auf $10^{-14}$ F gesenkt werden. Dies bedeutet, dass nun Signaländerungen verfolgt werden können, deren Frequenz bis zu 100 Hz beträgt. Die Bandbreite konnte also erfindungsgemäß im Vergleich zu einem sehr guten, kommerziell erhältlichen Elektrometer um 2 Dekaden verbessert werden.

Anhand der nachfolgenden Figur wird ein Ausführungsbeispiel der Erfindung näher erläutert.

Ersatzschaltbild 1 umfasst eine Spannungsquelle sowie einen Widerstand $R_Q$. Ersatzschaltbild 1 gibt das physikalische Verhalten eines Piezoelementes wider. Das Piezoelement stellt einen sehr großen Ohmschen Widerstand dar, der im Ersatzschaltbild 1 durch $R_Q$ widergegeben ist. Die Spannung wird durch Streckung und Stauchung des Piezoelementes erzeugt.

Das Piezoelement ist an eine Masse $M_1$ mit einer Stirnseite elektrisch verbunden. Die gegenüber liegende Stirnseite ist an den "+"-Anschluss eines Operationsverstärkers 2 elektrisch angeschlossen. Ein Ersatzschaltbild 3 gibt die Eingangsimpedanz wider, die sich auf den "+"-Anschluss des Operationsverstärkers 2 bezieht. Ersatzschaltbild 3 umfasst eine Eingangskapazität $C_E$ sowie einen Eingangswiderstand $R_E$. Der Operationsverstärker 2 ist so geschaltet, dass der Ausgang dem Eingang nachfolgt. Hierunter ist zu verstehen, dass der Ausgang des Operationsverstärkers 2 mit dem "-"-Eingang bzw. -Anschluss des Operationsverstärkers 2 elektrisch verbunden ist. Operationsverstärker 2 ist ferner in üblicher Weise an eine Spannungsquelle angeschlossen. In der Figur wird beispielhaft eine symmetrische Spannungsversorgung von -15 Volt bis +15 Volt gezeigt.

Zwischen der elektrischen Verbindung 10 und dem BezugsPotenzial des Operationsverstärkers 2 liegt die Eingangsimpedanz des Operationsverstärkers. Das BezugsPotenzial des Operationsverstärkers 2 ist die Masse der Spannungsversorgung des Operationsverstärkers 2. Die Eingangsimpedanz wird durch die Parallelschaltung der Ersatzschaltbildelemente Eingangskapazität $C_E$ und Eingangswiderstand $R_E$ gebildet. $M_2$ ist also die Masse der Spannungsversorgung des Operationsverstärkers 2.

Der Ausgang von Operationsverstärker 2 führt zum "+"-Eingang eines Operationsverstärkers 4. Operationsverstärker 4 ist ebenfalls so geschaltet, dass der Ausgang dem Eingang nachfolgt. Der Ausgang des Operationsverstärkers 4 ist also elektrisch mit dem "-"-Eingang des Operationsverstärkers 4 verbunden. Operationsverstärker 4 wird gemäß Figur wiederum beispielhaft symmetrisch mit Spannung versorgt und zwar von -15 Volt bis +15 Volt. Der Ausgang des Operationsverstärkers 4 ist elektrisch mit der Masse $M_2$ verbunden.

Zwischen der Masse $M_1$ und dem Ausgang des Operationsverstärkers 2 ist ein konventionelles Spannungsmessgerät eingebaut.

Masse $M_1$ und Masse $M_2$ sind galvanisch getrennt. Dies ermöglicht eine sogenannte schwimmende Versorgung des Operationsverstärkers 2. Die schwimmende Versorgung ist erforderlich, um im Operationsverstärker 2 auftretende Potenzialdifferenzen bei parasitären Kapazitäten kompensieren zu können. Anstelle der symmetrischen Spannungsversorgung ist auch eine nicht symmetrische Spannungsversorgung möglich.

Das Piezoelement ist an den "+"Eingang von Operationsverstärker angeschlossen worden, damit der gewünschte, sehr große Eingangswiderstand $R_E$ vorliegt, der sehr viel größer als der ohmsche Widerstand $R_Q$ des Piezoelementes sein muss. Der Ausgang von Operationsverstärker 2 ist an den "+"Eingang von Operationsverstärker 4 anzuschließen, damit nicht invertiert und damit "kompensiert" wird.

Die am Operationsverstärker 4 angelegte Spannungsversorgung sollte so groß sein wie die am Operationsverstärker 2 angelegte Spannungsversorgung. Andernfalls kann es vorkommen, dass bei parasitären Kapazitäten auftretende Potenzialdifferenzen nicht kompensiert werden.

Als Operationsverstärker werden klassische elektrometrische Operationsverstärker eingesetzt. Ein solcher Operationsverstärker weist idealerweise eine sehr große Verstärkung bei geöffneter Schleife auf. Der Eingangswiderstand ist sehr groß und sollte bei $10^{12}$ bis $10^{15}$ Ohm liegen. Ultrakleine Eingangsströme von $10^{-12}$ bis $10^{-15}$ A sollten für den Betrieb des Operationsverstärkers ausreichen. Der Ausgangswiderstand der eingesetzten Operationsverstärker sollte lediglich wenige Ohm betragen. Die Eingangskapazität sollte möglichst gering sein und in der Größenordnung von $10^{-12}$ F liegen. Erwünscht ist eine relativ große Gleichtaktunterdrückung im Bereich von 100 Dezibel.

Im Ausführungsbeispiel dient Operationsverstärker 2 der Erfassung einer Potenzialdifferenz. Operationsverstärker 4 dient der Potenzialnachführung. Die beiden Operationsverstärker können identisch sein.

Vorteilhaft weist Operationsverstärker 4 eine höhere Bandbreite als Operationsverstärker 2 auf, damit die Potenzialnachführung möglichst schnell erfolgt. Falls die Bandbreite von Operationsverstärker 4 geringer als die von Operationsverstärker 2 ist, kann ein instabiles Verhalten die Folge sein. Das instabile Verhalten kann zur Folge haben, dass die gewünschte Messung nicht möglich ist.

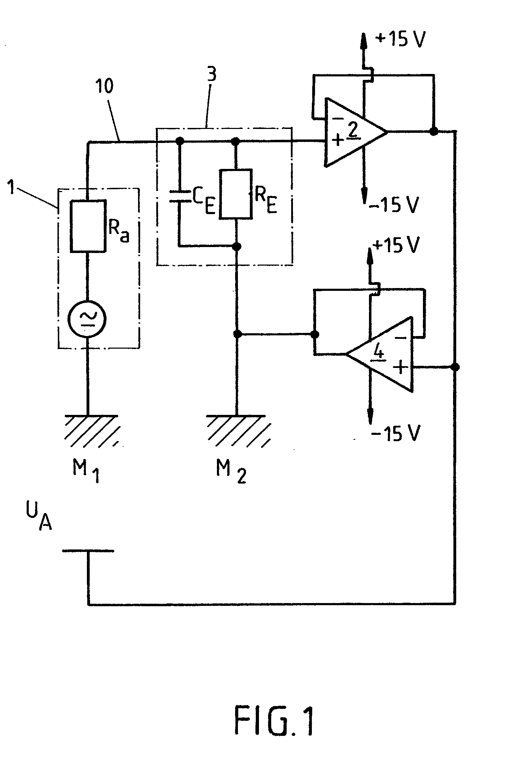

Bei der in der Figur 1 gezeigten Schaltung kann aus folgenden Gründen ein konventionelles Spannungsmessgerät zur Messung der Spannung zwischen der Masse $M_1$ und dem Ausgang von Operationsverstärker 2 verwendet werden.

Die Potenziale vor und hinter dem Operationsverstärker 2 sind identisch. Vor dem Operationsverstärker beträgt der Widerstand $R_Q$ vom Piezoelement regelmäßig ca. $10^{12}$ Ohm. Am Ausgang von Operationsverstärker 2 ist der Ausgangswiderstand (gemäß Ersatzschaltbild) sehr klein. Hier fällt die Potenzialdifferenz also an einem sehr kleinen Widerstand ab. Wegen des sehr kleinen Ausgangswiderstandes sind die in der Beschreibungseinleitung genannten Probleme praktisch bedeutungslos. Folglich kann ein konventionelles Spannungsmessgerät eingesetzt werden.

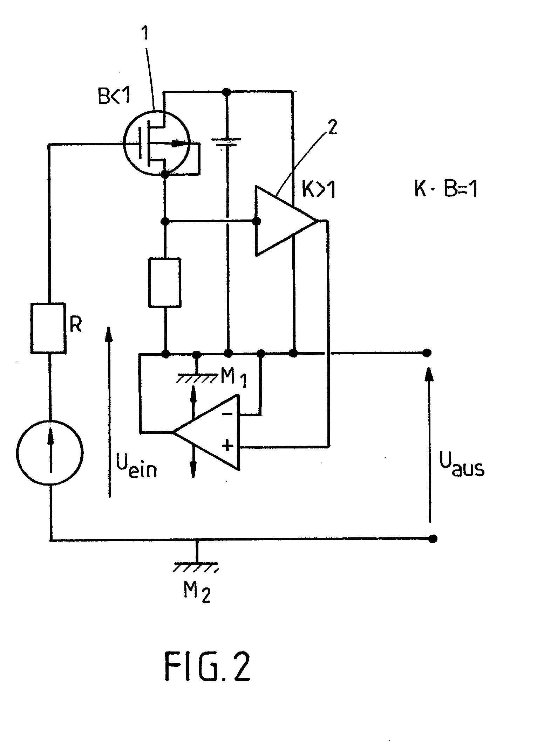

Figur 2 zeigt ein weiteres Ausführungsbeispiel eines erfindungsgemäßen Elektrometers.

Hinzuweisen ist insbesondere darauf, dass ein MOSFET 1 als Folger mit einer Verstärkung B<1 vorgesehen ist. Die Verstärkung B liegt ferner nahe 1. Die Verstärkung B beträgt also zum Beispiel 0,95. Operationsverstärker 2 weist eine solche Verstärkung K auf, dass das Produkt der beiden Verstärkungen B und K bei 1 liegt (B·K=1).

Durch die Erfindung wird der bereits erwähnte Vorteil gegenüber dem eingangs genannten Stand der Technik erzielt, wonach nun sehr schnelle Spannungsänderungen gemessen werden können.

Unter anderem im Bereich der Biophysik besteht Bedarf für das erfindungsgemäße Elektrometer. So liegt ein elektrische Widerstand $R_Q$ eines Zellpotenzials regelmäßig bei ca. $10^{11}$ Ohm.

**Patentansprüche**

1. Elektrometer mit Mitteln zur Messung und Ausgabe einer elektrischen Spannung, mit Bauelementen, bei denen parasitäre Kapazitäten im Inneren der Bauelemente auftreten, **gekennzeichnet durch** eine elektronische Einrichtung, die die auftretenden Potenzialdifferenzen bei den vorgenannten parasitären Kapazitäten registriert und registrierte Potenzialdifferenzen elektronisch reduziert.

2. Elektrometer nach Anspruch 1, bei denen als Bauelemente integrierte Schaltkreise, MOSFET-Transistoren, elektrometrische Röhren und/oder parametrische Verstärker vorgesehen sind.

3. Elektrometer nach einem der vorhergehenden Ansprüche, der zwei Operationsverstärker (2, 4) umfasst, wobei der Ausgang eines Operationsverstärkers (2) mit dem "+"Eingang von Operationsverstärker (4) verbunden ist, wobei beide Operationsverstärker so geschaltet sind, dass der Ausgang dem Eingang nachfolgt, wobei der "+"Eingang des ersten Operationsverstärkers (2) sowie der Ausgang des zweiten Operationsverstärkers (4) an einer gemeinsamen Masse ($M_2$) angeschlossen sind.

4. Elektrometer nach dem vorhergehenden Anspruch, die Bandbreite des zweiten Operationsverstärker (4) größer als die Bandbreite des ersten Operationsverstärkers (2) ist.

5. Verwendung eines Elektrometers nach einem der vorhergehenden Ansprüche zur Messung von Zellpotenzialen.

FIG.1

FIG.2

EP 1 281 976 A1

**Europäisches Patentamt**

**EUROPÄISCHER RECHERCHENBERICHT**

Nummer der Anmeldung

EP 01 11 8239

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int.Cl.7) |
|---|---|---|---|
| X | R.D.PURVES: "High-impedance electronics" WIRELESS WORLD, Bd. 89, Nr. 1566, 1983, Seite 31,32,66 XP002187022 GB * Seite 31, mittlere Spalte, Absatz 3 - Seite 32, rechte Spalte, Absatz 2; Abbildungen 3-5 * | 1-5 | G01R19/00 |
| X | EP 0 536 972 A (TEKTRONIX INC) 14. April 1993 (1993-04-14) * Zusammenfassung; Abbildung 1 * * Spalte 3, Zeile 37 - Spalte 4, Zeile 21 * | 1-4 | |
| X | US 4 646 002 A (TUSZYNSKI ALFONS A) 24. Februar 1987 (1987-02-24) * Zusammenfassung; Abbildungen * | 1-4 | |
| X | EP 0 300 494 A (NIPPON TELEGRAPH & TELEPHONE) 25. Januar 1989 (1989-01-25) * Zusammenfassung; Abbildungen 7-9 * | 1-4 | RECHERCHIERTE SACHGEBIETE (Int.Cl.7) |
| X | US 3 729 675 A (VOSTEEN R) 24. April 1973 (1973-04-24) * Zusammenfassung; Abbildung 5 * | 1-4 | G01R H03F H01L |
| X | EP 0 266 551 A (MONROE ELECTRONICS INC) 11. Mai 1988 (1988-05-11) * Zusammenfassung; Abbildungen 1,3,7 * | 1-4 | |
| X | US 5 083 095 A (MADAFFARI PETER L) 21. Januar 1992 (1992-01-21) * Zusammenfassung; Abbildungen 1,5,6 * | 1-4 | |

Der vorliegende Recherchenbericht wurde für alle Patentansprüche erstellt

| Recherchenort | Abschlußdatum der Recherche | Prüfer |
|---|---|---|
| BERLIN | 10. Januar 2002 | Fritz, S |

KATEGORIE DER GENANNTEN DOKUMENTE

X : von besonderer Bedeutung allein betrachtet
Y : von besonderer Bedeutung in Verbindung mit einer anderen Veröffentlichung derselben Kategorie
A : technologischer Hintergrund
O : nichtschriftliche Offenbarung
P : Zwischenliteratur

T : der Erfindung zugrunde liegende Theorien oder Grundsätze
E : älteres Patentdokument, das jedoch erst am oder nach dem Anmeldedatum veröffentlicht worden ist
D : in der Anmeldung angeführtes Dokument
L : aus anderen Gründen angeführtes Dokument
& : Mitglied der gleichen Patentfamilie, übereinstimmendes Dokument

7

**ANHANG ZUM EUROPÄISCHEN RECHERCHENBERICHT**
**ÜBER DIE EUROPÄISCHE PATENTANMELDUNG NR.**                    EP 01 11 8239

In diesem Anhang sind die Mitglieder der Patentfamilien der im obengenannten europäischen Recherchenbericht angeführten Patentdokumente angegeben.
Die Angaben über die Familienmitglieder entsprechen dem Stand der Datei des Europäischen Patentamts am
Diese Angaben dienen nur zur Unterrichtung und erfolgen ohne Gewähr.

10-01-2002

| Im Recherchenbericht angeführtes Patentdokument | Datum der Veröffentlichung | Mitglied(er) der Patentfamilie | Datum der Veröffentlichung |
|---|---|---|---|
| EP 0536972 A | 14-04-1993 | US 5151775 A<br>DE 69219716 D1<br>DE 69219716 T2<br>EP 0536972 A2<br>JP 6021335 A | 29-09-1992<br>19-06-1997<br>04-09-1997<br>14-04-1993<br>28-01-1994 |
| US 4646002 A | 24-02-1987 | KEINE | |
| EP 0300494 A | 25-01-1989 | DE 3878069 D1<br>DE 3878069 T2<br>EP 0300494 A2<br>JP 1105605 A<br>JP 2759128 B2<br>KR 9307292 B1<br>US 4885548 A | 18-03-1993<br>29-07-1993<br>25-01-1989<br>24-04-1989<br>28-05-1998<br>04-08-1993<br>05-12-1989 |
| US 3729675 A | 24-04-1973 | KEINE | |
| EP 0266551 A | 11-05-1988 | DE 3788036 D1<br>EP 0266551 A1<br>EP 0327577 A1<br>JP 63171373 A<br>JP 2503252 T<br>WO 8802953 A1<br>US 4843344 A<br>US 4853639 A | 09-12-1993<br>11-05-1988<br>16-08-1989<br>15-07-1988<br>04-10-1990<br>21-04-1988<br>27-06-1989<br>01-08-1989 |
| US 5083095 A | 21-01-1992 | KEINE | |

EPO FORM P0461

Für nähere Einzelheiten zu diesem Anhang : siehe Amtsblatt des Europäischen Patentamts, Nr.12/82